# EUROPEAN PATENT APPLICATION

(11) **EP 0 817 554 A1**
(43) Date of publication of application: **07.01.1998**
(21) Application number: 97109958.5
(22) Date of filing: 18.06.1997
(51) Int. Cl.: H05K 7/20, F24F 13/10

(54) **Blower check-flap for a cooling system**

(30) Priority: 27.06.1996 US 672142
(71) Applicant: DIGITAL EQUIPMENT CORPORATION, Maynard, Massachusetts 01754 (US)
(72) Inventor: Collins, Pat E., Colorado Springs, Colorado 80918 (US)
(74) Representative: Betten & Resch

(57) **Abstract**

An air flow control that has a housing with an exit opening through which air is moved to exhaust, and a sheet of springy material with resistance to creep and a memory bias towards its closed position mounted on the housing. The sheet is mounted so as to be disposed over the opening to prevent entrance of air into the housing through the opening. The springy material allows movement of the sheet away from the opening to allow movement of air through the opening when air is exhausted therethrough. The springy material also urges the sheet because of its memory bias over the opening to prevent entrance of outside air into the housing through the opening when no air is being removed to exhaust through the opening.

## Description

### BACKGROUND OF THE INVENTION

The present invention generally relates to cooling systems and more particularly to fan or blower cooled redundant cooling systems.

Electronic system enclosures often employ fan/blower cooled redundant systems for cooling. A typical fan/blower cooled redundant cooling system may use two fans or blowers for cooling. Each fan or blower has an associated opening located on the system enclosure through which hot air is removed from the system enclosure to exhaust the enclosure.

When one of the blowers/fans fails, the operable one is able to draw air into the electronic system through the exhaust opening associated with the inoperable fan, causing an undesirable backflow of air. However, this backflow of air into the failed fan/blower impairs the ability of the operable blower to cool the system.

Cooling modules also known as fan packs are well known in the art. US Pat. No. 3,967,874 to Calabro, US Pat. No. 4,502,099 to Manes, and US Pat. No. 3,249,038 to Johnson, teach systems which while operating generally satisfactorily for their intended purposes, have been found to be ineffective and unusable in cooling electronic circuitry, specifically, preventing backflow into a failed fan/blower, when mounted in a vertically oriented equipment frame.

Additionally, US Pat. No. 4,648,007 to Garnar teaches an arrangement that is effective in cooling electronic circuitry mounted in a vertically oriented equipment frame. However, Garner*'*s arrangement is ineffective and unusable in cooling electronic circuitry mounted in a non-vertically oriented equipment frame.

Hence, there is a need for a cooling arrangement that is effective in cooling electronic circuitry, specifically, preventing backflow into a failed fan/blower, for any and all orientations of the equipment frames.

### SUMMARY OF THE INVENTION

An object of this invention is to provide an air flow control apparatus for a cooling system.

The apparatus described herein enhances the cooling efficiency of a redundant blower/fan cooled electronic system, especially when a fan/blower fails, and prevents an operable fan/blower from drawing in air through a failed blower/fan opening in a redundant blower/fan cooled electronic system.

Described hereinafter is an air flow control apparatus that prevents backflow of air through a failed fan/blower using no mechanical moving parts.

In one aspect, these and other objects of this invention are attained by an air flow control apparatus that has a housing with an exit opening through which air is removed to exhaust, and a flap-like sheet of resilient material mounted on the housing, said sheet of resilient material having a memory to return the sheet of resilient material to its closed position. The sheet of material is disposed over the opening to prevent entrance of air into the housing through the opening. The resilient material allows movement of the sheet away from the opening to allow movement of air through the opening when air is exhausted therethrough. The resilient material, because of its memory, also urges the sheet to cover the opening to prevent entrance of air into the housing through the opening when no air is being moved to exhaust through the opening.

In another aspect, these and other objects of this invention are attained by an air flow control apparatus that has a housing with an exit opening through which air is moved to exhaust, and also has a first and second sheet of resilient or springy material with a memory biasing the sheets to their closed position. Each sheet is mounted on the housing so as to be disposed over the opening to prevent entrance of air into the housing through the opening. The springy material allows movement of each sheet away from the opening to allow movement of air through the opening when air is exhausted therethrough. The springy material also urges each sheet over the opening in a flap-like manner using the memory characteristics of the material to prevent entrance of air into the housing through the opening when no air is being moved to exhaust through the opening.

The invention, in its broad form, resides in an airflow control apparatus, as recited in claim 1.

An advantage of this invention is an air flow control apparatus that can function independent of its orientation.

Yet another advantage of this invention is an air flow control system, the performance of which does not degrade with time because it has no mechanical moving parts.

Another advantage of this invention is an air flow control system that works with vane-axial fans, tube-axial fans, centrifugal blowers, and with other air moving devices, without any special modifications.

### BRIEF DESCRIPTION OF THE DRAWINGS

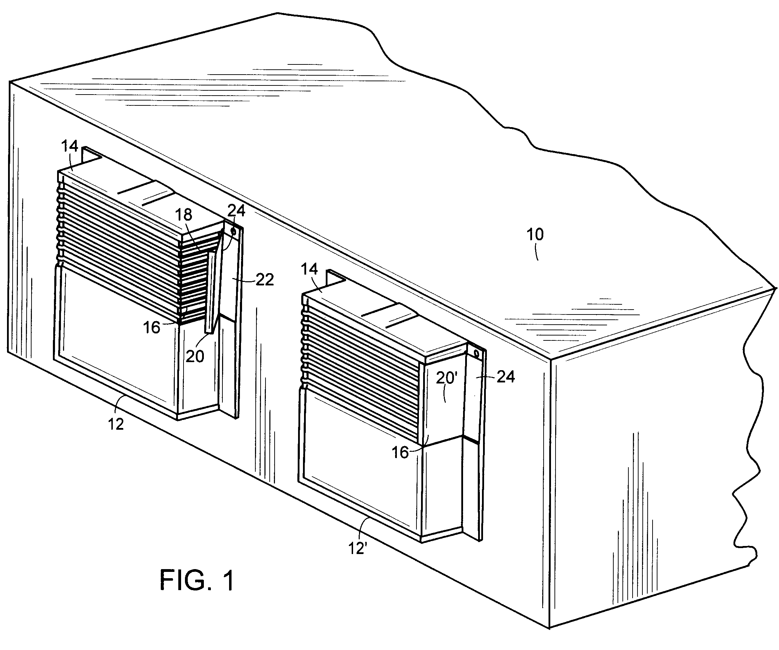

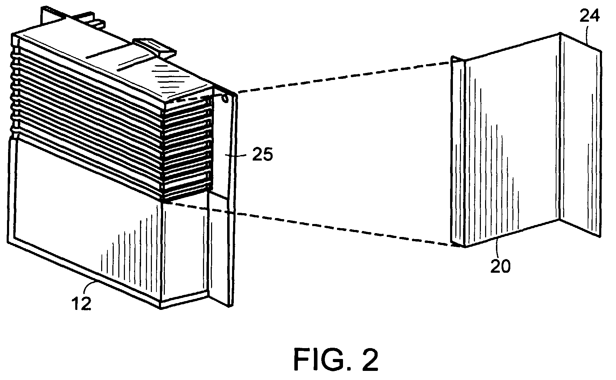

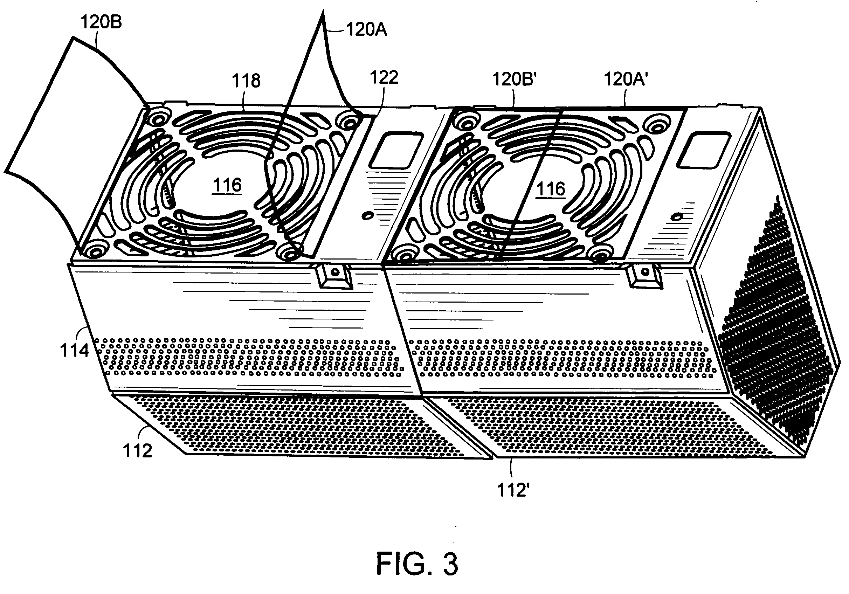

A more detailed understanding of the invention can be had from the following description of a preferred embodiment, given by way of example, and to be read and understood in conjunction with the accompanying drawings wherein:
◆ Figure 1 is a perspective view of an enclosure including a cooling system with air control apparatus in accordance with a preferred embodiment of the invention.
◆ Figure 2 is an enlarged perspective view of the air control apparatus Figure 1. Figure 2A is a schematic of a sheet used in the air control apparatus of Figures 1 & 2.
◆ Figure 3 is a perspective view of an enclosure illustrating a second embodiment of air control apparatus.

### DESCRIPTION OF THE PREFERRED EMBODIMENT

There is shown in Figure 1 a simplified representation of an enclosure 10 that employs a redundant blower cooling system embodying the principles of the invention. In Figure 1, the redundant blower cooled system is shown to comprise of two air flow control apparatus 12, 12'. Enclosed in enclosure 10 (not shown) can be electronic circuitry or other apparatus that are in need of cooling for effective performance.

As shown in Figure 1, each air flow control apparatus 12, 12' has a housing 14. Enclosed in each housing 14 (not shown) is an air moving device such as a vane-axial fan, a tube-axial fan, or a centrifugal blower.
Also as shown in Figure 1, each air flow control apparatus 12, 12' has an exit opening 16 through which air is moved to exhaust out of the enclosure 10. In the embodiment shown, the exit opening 16 is covered with a grill 18. When in operation, the air moving device, such as a fan or a blower, enclosed in each housing 14 moves warm or hot air from inside the enclosure 10 through each air control apparatus 12, 12' and exhausts the warm air out through each opening 16.

Further, as shown in Figure 1, a sheet 20, 20' of springy material is mounted on each housing 14. The sheet 20, 20' can be mounted on the housing in a number of different ways. Good results were obtained by mounting the sheet 20, 20' as shown in Figures 1, 2 and 2a.

In the embodiment shown in Figures 1, 2 and 2a, the sheet 20, 20' is mounted on the housing 14 for pivotal movement against the memory bias of the sheet 20, 20*'* away from the opening 16. The mounting of the sheet 20, 20' for pivotal movement allows movement of air through the opening 16 when air is moved to exhaust therethrough. As shown, the sheet 20, 20' may be mounted along one of its side 22 adjacent the opening 16. The sheet 20, 20' is shown partially folded along a crease 24 defining side 22 along which the sheet 20, 20' is mounted. The sheet 20, 20' is shown mounted on the housing 14 using double-sided adhesive tape 26 that is affixed to the sheet 20, 20' at side 22.

It is understood that the manner of mounting of the sheet 20, 20' can be one of many possible ways. The broad principles of the invention are intended to encompass any of the many different specific implementations.

When the air moving device enclosed in each housing 14 is idle, no air is moved to exhaust out of enclosure 10. As shown in Figure 1, air control apparatus 12' represents such a case. When the air moving device is idle, the sheet 20' is disposed over the opening 16 preventing entrance of air into the housing 14 through the opening 16.

As shown in Figures 1, 2, 2a, the sheet 20, 20' is made of a springy material. The springy material urges the sheet 20, 20', regardless of its spatial orientation and without the aid of any assistance or gravity, to cover the opening 16 to prevent entrance of outside air into the housing 14 through the opening 16 when the air moving device is not in operation and no air is being moved to exhaust through the opening 16.

When the air moving device enclosed in each housing 14 is in operation, it moves warm or hot air from inside the enclosure 10 to exhaust through each opening 16. The air being moved to exhaust out through opening 16 causes the sheet 20, 20' to move away from the opening 16 to allow movement of air through the opening 16. As shown in Figure 1, air control apparatus 12 represents such a case.

Good results were obtained by using a polyester film, such as MYLAR®, as the material for sheet 20, 20'. MYLAR® is a registered trademark of DuPont Corporation. However, other materials may also be used instead. The material used must have excellent resistance to creep when heated, like MYLAR® does. Resistance to creep is important because the air exiting the air flow control apparatus 12, 12' is warm and may otherwise cause the material to deform.

Further, the material used must have appropriate position memory characteristics and a bias which allows the sheet 20, 20' to urge itself toward the opening 16, without the aid of gravity, to close the opening when the air moving device either fails or is idle, thereby preventing entrance of outside air into the enclosure 10. According to the principles of this invention, it is this self-urging property of the material used for sheet 20, 20' and caused by its memory characteristics, which allows the air flow control apparatus 12, 12' to be used in any orientation, vertical or horizontal.

Further, good results were obtained by using a sheet 20, 20' of polyester material, particularly MYLAR® that was 0.002 inches thick. However, the sheets 20, 20' may be 0.002 - 0.008 inches thick and still operate effectively. In the embodiment shown, the sheet 20, 20' is rectangular and measures 2.2 inches x 2.3 inches. However, it is understood that a sheet of polyester film, such as MYLAR®, 0.002 inches thick and measuring 2.2 inches x 2.3 inches, is one of many possible embodiments.

It is significant that the performance of the MYLARⓇ film elements 20 and 20*'* will not deteriorate even after particulate build up such with the accumulation of lint/dust thereon.

The size and thickness of the sheet 20, 20' depend upon the size of the opening 16 and other cooling performance considerations. The broad principles of the invention are intended to encompass any of the many different specific implementations.

As described herein, in the event that one of the air moving devices of a redundant cooling system fails, the air flow control apparatus associated with the failed device prevents air from being drawn into the enclosure through the opening associated with the failed device.

Consequently, the air flow control apparatus improves the cooling performance of a redundant cooling system utilizing blowers or fans.

Referring now to Figure 3 there is shown an alternative embodiment of an air control apparatus 112, 112'. The air control apparatus 112, 112', each have a housing 114. The housing 114 has an exit opening 116 through which air is moved to exhaust therefrom. The exit opening 116 is shown covered with a grill 118.

Also, as shown in Figure 3, the air flow control apparatus 112, 112' has a first sheet of springy material 120a, 120a' mounted on the housing 114, and a second sheet of springy material 120b, 120b' mounted on the housing 114.

According to the principles of the invention, as shown, the first sheet 120a, 120a' and the second sheet 120b, 120b' are mounted so as to be disposed over the opening 116 and combine to prevent entrance of air into the housing 114 through the opening 116. As shown, the springy material allows movement of each sheet 120a, 120a', 120b, 120b' away from the opening 116 to allow movement of air through the opening 116 when air is exhausted therethrough.

Further, as shown, the springy material urges each sheet 120a, 120a', 120b, 120b' over the opening 116, without any external assistance, to prevent entrance of air into the housing 114 through the opening 116 when no air is being moved to exhaust therethrough.

The sheets 120a, 120a', 120b, 120b', as shown, are made of MYLAR®. However, as discussed above other materials can be used as well.

It is apparent that, within the scope of the invention, modifications and different arrangements may be made other than as herein disclosed. The present disclosure is merely illustrative, the invention comprehending all variations thereof.

## Claims

1. Air flow control apparatus comprising:
a housing having an exit opening through which air is moved to exhaust therefrom; and
at least one sheet of springy material with resistance to creep and having a position memory mounted on the housing so as to be disposed over the exit opening to prevent entrance of outside air into the housing through the opening, the springy material allowing resilient movement of the sheet away from the opening to allow movement of air through the opening when air is exhausted therethrough, the springy material having a bias urging the sheet over the opening to prevent entrance of air into the housing through the opening when no air is being moved to exhaust therethrough.

2. The air flow control apparatus of Claim 1 wherein the sheet of springy material is mounted along one side thereof adjacent the opening.

3. The air flow control apparatus of Claim 1 wherein the sheet of springy material comprises a polyester film.

4. The air flow control apparatus of Claim 3 wherein the polyester film comprises MYLAR®.

5. Air flow control apparatus as in claim 1 comprising:
a second sheet of springy material mounted on the housing, the first and second sheet each having a bias and being mounted so as to be disposed over the opening and combining to prevent entrance of outside air into the housing through the opening.

6. The air flow control apparatus of Claim 5 wherein each sheet of springy material is mounted along one side thereof adjacent the opening.

7. Airflow control apparatus as in any preceding claim, wherein the springy material is in the thickness range of .002" to .008".

8. Airflow control apparatus as in any preceding claim, wherein the springy material comprises .002" thick MYLARⓇ.
